# EUROPEAN PATENT APPLICATION

(11) **EP 3 644 251 A1**
(43) Date of publication of application: **29.04.2020**
(21) Application number: 19205163.9
(22) Date of filing: 24.10.2019
(51) Int. Cl.: G06Q 10/08, G09F 3/03, G01R 31/08, G08B 13/12

(54) **ASSET TRACKING DEVICE AND METHOD FOR SEALING AN ASSET**

(30) Priority: 24.10.2018 EP 18202423
(71) Applicant: Alps Electric Europe GmbH, 85716 Unterschleissheim (DE)
(72) Inventor: KUNZMANN, Sascha, 86987 Schwabsoien (DE); BACHMAYER, Mathias, 85748 Garching (DE)
(74) Representative: Maiwald Patent- und Rechtsanwaltsgesellschaft mbH

(57) **Abstract**

Asset tracking device (10) comprising an inner compartment (30), at least two electrodes (41, 42), disposed spaced apart from each other in the inner compartment (30), a seal (50), comprising electrically conductive material, being disposed outside of the inner compartment (30) such that the seal (50) capacitively couples the at least two electrodes (41, 42), an evaluation device (70), which is electrically connected to the at least two electrodes (41, 42) and is configured to determine a charge transfer between the electrodes (41, 42) along the seal (50) induced by at least one voltage step applied to one of the electrodes (41, 42); wherein the evaluation device (70) is configured to detect a change of seal (50) state based on the charge transfer.

## Description

### FIELD OF THE INVENTION

The present invention relates to an asset tracking device with a seal for sealing the asset to be tracked.

### BACKGROUND OF THE INVENTION

Sealing a closed asset is generally performed, in order to be sure that the asset was not opened by a non-approved person. The seal does not prevent anyone from opening the asset, but when the asset is opened, the seal automatically breaks and it is apparent to everyone that the asset has been opened.

To date, the open/closed state of a seal is only monitored by manual inspection. For example, armored transport vehicles are usually sealed when they are fully loaded. When the storage room of the transport vehicle gets sealed, an officer scans a bar code and the time and location of the vehicle is transmitted to an external device. Therefore, the time and location of sealing the vehicle is stored. The same procedure can be repeated, when the seal is broken and the vehicle is unloaded. When the bar code is scanned again, the time and location of breaking the seal is transmitted to the external device. The same concept applies to other assets to be sealed, like doors, flaps, lids, latches, close letters or parcels, containers or boxes. However, when for whatever reason the bar code is not scanned or the seal gets broken by a non-approved person, the time and location of breaking the seal is not known or stored.

### SUMMARY OF THE INVENTION

The present invention has been made in view of such circumstances and provides an improved asset tracking device, which is also configured to seal an asset, wherein a change of seal state, in particular, if a seal is intact or broken, can be automatically detected.

In an aspect of the present invention asset tracking device comprises an inner compartment, at least two electrodes, disposed spaced apart from each other in the inner compartment, a seal, comprising electrically conductive material, being disposed outside of the inner compartment, such that the seal capacitively couples the at least two electrodes, an evaluation device, which is electrically connected to the at least two electrodes and is configured to determine a charge transfer between the electrodes along the seal induced by at least one voltage step applied to one of the electrodes. The evaluation device is configured to detect a change of seal state based on the determined charge transfer.

The term "asset tracking device" (ATD) includes all devices that track or monitor assets. Therefore, in particular "condition monitoring devices" (CMD) are also subsumed by asset tracking devices.

The term "tracking device" does not only include devices, which are constantly monitoring a certain value, like location, temperature, etc. Even when a device is determining a certain value only at predetermined time periods or also at totally irregular time periods, the device still is subsumed as a tracking device.

The term "seal state" defines the state the seal is in. Preferably, the seal state knows two states, "on" and "off". The seal state is "off", when it is detected that the seal has been removed or broken. Additionally, the seal state is "on", when it is detected that the seal is intact.

The term "lead seal" describes the general function of an asset being secured by a seal. The seal itself is thereby a part of the whole arrangement. For example, "lead seal" comprises all parts including the seal itself function together to create the "lead seal" and the functionality thereof. Verbal and adverbial constructions can also be used. In this case the asset tracking device with the seal form a lead seal at an asset, or in other words lead seal the asset.

The term "voltage step", as used herein, describes a positive or negative edge of voltage with a steep flank, ideally a rectangular edge. In other words, the voltage step describes a single step of a square wave. In other words, the voltage step describes an abrupt increase or decrease in electrical potential.

The term "charge transfer", as used herein, describes a quantity of charge transfer between the electrodes.

The term "along the seal", as used herein, can also be understood as through the seal, via the seal and/or over the seal.

Preferably, the voltage step is applied to one of the electrodes by the evaluation device.

In other words, a voltage step is applied to one of the electrodes. The voltage step of the electrode raises an electrical potential of the adjacent end of the capacitively coupled seal. The raised electrical potential leads to a charge transfer along the seal to the other end of the seal. There, the electrical potential is also raised due to the charge transfer, raising the electrical potential of the other electrode capacitively coupled to the other end of the seal. The evaluation device can thus detect the charge transfer based on the change of electrical potential of the other electrode.

According to the disclosure of the invention the evaluation unit can be understood by the person skilled in the art as a seal state detection unit, or every other unit that is configured to determine date in order to detect the state of a seal.

In a preferred embodiment, the asset tracking device is disposed at an asset, such that the seal lead seals the asset itself or the access to the asset, like a door, flap, lid, latch, parcels, letters, containers or boxes, in all shapes and forms. Therefore, whenever the asset is accessed, the seal will break and the evaluation device will detect a change of the seal state.

In a preferred embodiment, the seal is an electrically conductive body e.g. a foil, which can be isolated by a non electrically conductive material, in particular rubber or plastic. Preferably, the seal and the at least two electrodes are electrically isolated. Since the evaluation device only determines the quantity of charge transfer, which preferably depends on the impedance between the electrodes, the seal does not need to be electrically connected to the electrodes in order to affect the evaluation device. When the seal is disposed in such a way that the electrodes are capacitively coupled, a charge transfer induced at one electrode by applying a voltage step can be detected at the capacitively coupled other electrode Therefore, the evaluation device just has to detect a charge transfer at one electrode in order to evaluate, if the seal was removed/broken or if the seal is still intact.

The detection of the seal state is therefore possible, although the seal itself is structurally independent from the inner compartment.

In a preferred embodiment, all current carrying parts of the asset tracking device are disposed in the inner compartment.

In a preferred embodiment, the asset tracking device preferably comprises more than two electrodes, as long as not all electrodes are electrically connected to each other.

The tracking device preferably comprises an energy storage device, which supplies the tracking device with power. The energy storage device preferably is a battery or a capacitor, for example deriving its energy from an energy harvester of some sort.

The asset tracking device preferably is configured to be reused. When the seal is broken, the seal can be removed from the asset tracking device and a new seal can be added. Therefore, the number of reuse cycles of the asset tracking device is mainly dependent of the used energy storage device. If the asset tracking device is configured to be reused, the energy storage device will be a long life battery, or a rechargeable accumulator. On the other hand, if the asset tracker is configured to be only used once, the energy storage device will be a capacitor or battery cell with low capacity, with by comparison a lower lifetime. In such a case, the capacity of the energy storage device is pre calculated in view of the expected lifetime of the seal of the asset tracking device.

However, since the general expenses of the proposed asset tracking device are relatively low, a non-reusable version that can only be used once, might also be cost efficient.

Preferably, the evaluation device is formed from analog electrical parts only.

Since the task to be performed by the evaluation device can be provided by analog electrical parts only, no additional, relatively expensive, micro controllers have to be used.

Preferably, the electrode to which the voltage step is applied is called driven electrode, while the other electrode is called non-driven electrode.

Preferably, the seal comprises an electrically strong conductive material, in particular metal. The charge transfer preferably has a relatively small value. Thus, the change of electrical potential at the non-driven electrode also has a relatively small value compared to the induced voltage step. When using a seal with relatively strong electrical conductivity, the change of electrical potential at the other end of the seal reaches a measureable amount of about 100 mV when inducing a voltage step of a couple of volt, in particular 3,3V or 5V, at the opposing electrode.

The evaluation device thus only needs to apply at least one voltage step to one of the electrodes and analyse the charge transfer between the electrodes, in particular measured by the charge amplifier. The evaluation device thus can operate in a relatively simple way, which does lead to a decreased power consumption. Additionally, the timing of one measurement is relatively short. Preferably, the time between applying the voltage step and detecting the charge transfer is below 5 milliseconds. Compared to for example a relatively complex impedance measurement of the seal, the proposed method is around ten times faster. Thus, the power consumption of the asset tracking device is further reduced. Thus, the life time of the asset tracking device is increased.

Preferably, the inner compartment is water- and/or dust proof.

Preferably, the sealing of the inner compartment complies with protection class IP67.

Depending on budget aspects, the inner compartment can be implemented and sealed with two or three different components.

Preferably, the inner compartment includes all parts, which are vulnerable to external/environmental influences, like water or dust. For example, the inner compartment comprises an upper compartment half and a lower compartment half, being fixed to each other by screws, bolts and/or a snap-mechanism. Alternatively, the inner compartment is integrally formed by a moulded or shrunk or welded-in film, foil or foam. Integrally formed inner compartments are generally cheaper in production, but do not have the ability to be opened without being destroyed. In asset tracking devices with a changeable energy storage device, which therefore have longer life time, integrally formed inner compartments cannot be used.

Preferably, the evaluation device and/or the localization device and/or the transmission device are disposed in the inner compartment.

Preferably, all electronic parts of the asset tracking device are disposed in the inner compartment. When the inner compartment is water- and/or dust proof, the electronic parts are protected. This increases the life time of the asset tracking device and reduces malfunction.

It is preferred that the asset tracking device comprises a charge amplifier, which is configured to measure the charge transfer and to provide the charge transfer, in particular an amplified charge transfer based on the charge transfer, to the evaluation device.

The charge amplifier is configured to amplify the measured charge transfer to a level that is capable of being coupled to the other electrode.

The charge transfer along the seal has a relatively small value dependent on the impedance of the seal. Thus, the charge amplifier is necessary to amplify the charge transfer to a level that is enough to induce raise in electrical potential of the adjacent electrode that is monitored by the evaluation device.

Preferably, the evaluation device comprises an input configured to receive the charge transfer from the charge amplifier. Due to the simplicity of the implementation, the evaluation device has only to measure a logical level of the input. Thus, the complexity of the evaluation device is reduced, leading to a reduced power consumption of the asset tracking device.

In a preferred embodiment, the charge amplifier is configured to measure a change of electrical potential at the electrode to which the at least one voltage step is not applied.

It is preferred that the evaluation device is configured to determine a charge transfer between the electrodes along the seal induced by one single voltage step applied to the one of the electrodes.

In the ideal case, only one single voltage step is necessary to measure a charge transfer between the electrodes.

Thus, the power consumption of the asset tracking device is reduced.

Alternatively, one or more test voltage steps can be applied to one of the electrodes to determine the general voltage level of the seal before applying the actual voltage step. Due to the relatively low value of charge transfer and thus high sensibility of the charge amplifier, a result of the evaluation device might be distorted by external factors, like a hand on the seal.

It is preferred that the asset tracking device comprises a localization device, configured to determine geographic data and information, or geodata, of the asset tracking device.

As described above, the asset tracking device can be configured to monitor several different useful properties. In view of the general application field, it is preferred that the asset tracking device allows the determination of geodata.

It is preferred that the asset tracking device comprises a transmission device, which is configured to transmit the detected change of seal state and/or allows the geolocation to an external device by radio frequency communication in a low-power wide-area network (LPWAN), for example Sigfox.

In a preferred embodiment, the detected seal state and/or the geographic data should be stored and processed by an external device, in particular further processing and database means. Therefore, the determined data has to be transmitted from the asset tracking device. Preferably, the transmission device comprises a radio device and an antenna. The data to be transmitted is relatively small, therefore, the transmission device can be configured as cheap as possible. One of the cheapest ways to transmit the data is using radio frequency communication in a low-power wired-are network (LPWAN), for example, as provided by Sigfox.

It is preferred that the seal comprises a first seal end portion, a second seal end portion and a connecting portion, connecting the first seal end portion and the second seal end portion, wherein the first seal end portion and the second seal end portion are at least partially received by the asset tracking device, wherein the connecting portion and an outer wall of the asset tracking device form a space, in which parts of the asset and/or the access to the asset are disposed to form a lead seal.

When the first seal end portion and the second seal end portion are received by the asset tracking device, the seal state is "on". Preferably, when accessing the asset, the lead seal, in particular the seal, breaks and the lead seal is irreversibly destroyed. The lead seal can thereby break, by cutting the seal in two or more parts or ripping the seal out of the asset tracking device. After that, the seal state is "off'.

In an alternative embodiment, one of the first seal end portion and the second seal end portion is irreversible connected to, preferably encapsuled with, the inner compartment. Therefore, this seal end portion is already disposed at the right position in view of the respective electrode. Therefore, only the respective other seal end portion is free to be used to form a lead seal with the asset. This embodiment is especially suitable for a single-use asset tracking device, since the seal cannot be renewed.

It is preferred that the inner compartment comprises a first wall and a second wall, the at least two electrodes comprise a first electrode and a second electrode, and the seal comprises a first seal end portion, a second seal end portion and a connecting portion, connecting the first seal end portion and the second seal end portion, wherein the first electrode is disposed on an inner surface of the first wall and the first seal end portion is disposed on an outer surface of the first wall, wherein the second electrode is disposed on an inner surface of the second wall and the second seal end portion is disposed on an outer surface of the second wall.

Preferably, the first wall and the second wall are disposed opposite to each other. Therefore, the connecting portion of the seal extends from the first wall to the second wall and capacitively couples the first electrode and the second electrode.

It is preferred that the seal is configured to be flexible and/or pre-bend, wherein the seal in particular is configured to have a U-shape, wherein the first seal end portion and the second seal end portion form the legs and the connecting portion forms the connecting part of the U-shape.

It is preferred that the asset tracking device comprises a seal receiving unit, which is disposed outside of the inner compartment and is configured to at least partially receive the seal.

The seal has to be attached to the asset tracking device, in particular to an outer wall of the asset tracking device, in a secure manner. Therefore, the seal can be at least partially received by the seal receiving unit. The seal receiving unit provides the function that a seal can be inserted in one direction, but after being inserted, cannot removed again from the seal receiving unit without destroying the seal.

The seal receiving unit preferably comprises a first seal receiving unit and a second seal receiving unit, which each are able to receive the first seal end portion and the second seal end portion, respectively. The first and second seal receiving units are disposed on the outer surface of the inner compartment, preferably at the sides, on which electrodes are disposed on the inner surface of the inner compartment.

It is preferred that the seal receiving unit comprises a mechanical self-locking mechanism, which is configured to lock the seal in only one direction.

In a preferred embodiment, the mechanical self-locking mechanism comprises at least two blades or snap-hooks for securing the seal. The blades preferably comprise deformed edges. Preferably, the seal receiving unit uses the principle of friction-self-locking and amplification by utilizing the kinematic bifurcation of the deformed blade's edges when the seal is inserted. In other words, the seal, in particular the first seal end portion and/or the second seal end portion, can be moved within the seal receiving unit in only one direction, the inserting direction. The other direction is blocked by the blades. Trying to move the seal in the direction against the blades, will lead to the seal being cut by the blades when exceeding a defined cut-off pull-force.

It is preferred that the evaluation device is configured to determine the charge transfer between the electrodes in predetermined intervals, in particular once per minute.

Determining the charge transfer between the electrodes in predetermined intervals, helps reducing the power consumption of the evaluation device and therefore of the asset tracking device. Depending on the asset, a balance has to be found between the power consumption and the resolution of the determined data.

It is preferred that the inner compartment is made of an electrically isolating material.

Therefore, the inner compartment does not influence an impedance of the electrodes and thus does not influence a charge transfer between the electrodes. Preferably, any additional parts of the asset tracking device, that are not the seal, the electrodes or electronic parts are made of an electrically isolating material. Preferably, isolating materials comprise plastic and rubber.

An aspect of the present invention includes a method for sealing an asset with an aforementioned asset tracking device.

It is preferred that the asset is a transport container, in particular a transport vehicle.

It is preferred that the method comprises the steps
capacitive coupling of the at least two electrodes by a seal;
determining the charge transfer between the electrodes along the seal and detecting a change of seal state by an evaluation device based on the charge transfer between the electrodes;
preferably transmitting the change of seal state to an external device, preferably by radio frequency communication, by the transmission device.

In aspect of the present invention includes a vehicle, with an aforementioned asset tracking device, preferably lead sealed by.an aforementioned asset device.

### BRIEF DESCRIPTION OF THE DRAWING

Fig. 1 shows a perspective sectional view of a first embodiment of the asset tracking device along cutting edge I.
Fig. 2 shows a bottom view of the asset tracking device.
Fig. 3 shows a side view of the asset tracking device.
Fig. 4 shows a side sectional view of the asset tracking device along cutting edge IV.
Fig. 5 shows a perspective view of a second embodiment of the asset tracking device.
Fig. 6 shows a perspective view of a third embodiment of the asset tracking device.

### DESCRIPTION OF THE PREFERRED EMBODIMENTS

An asset tracking device according to several embodiments of the present invention will be described below with reference to the drawings.

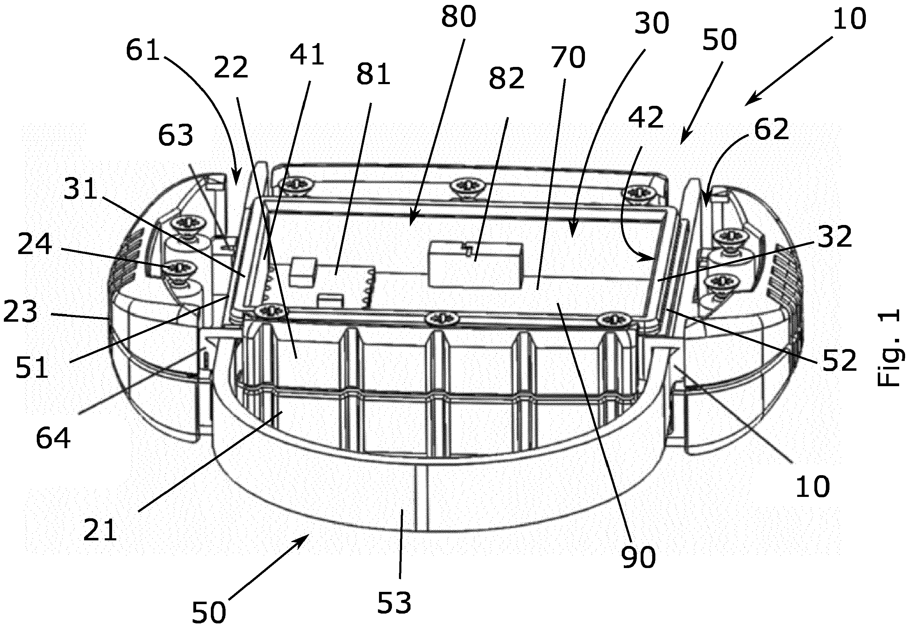

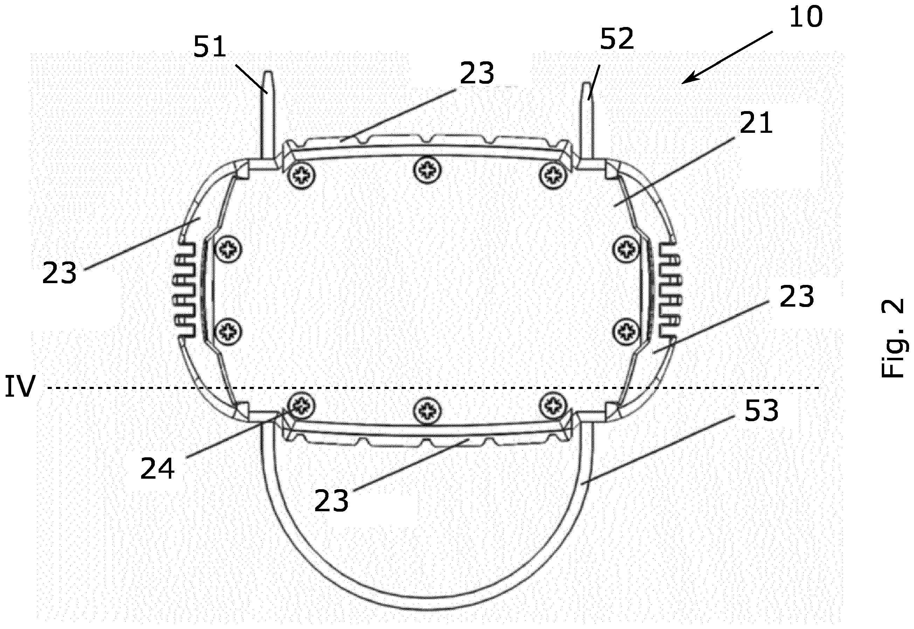

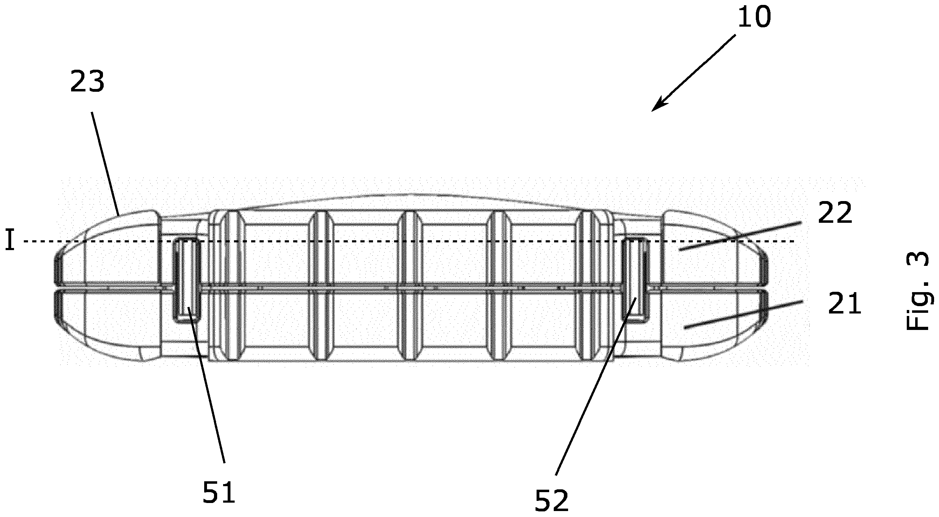

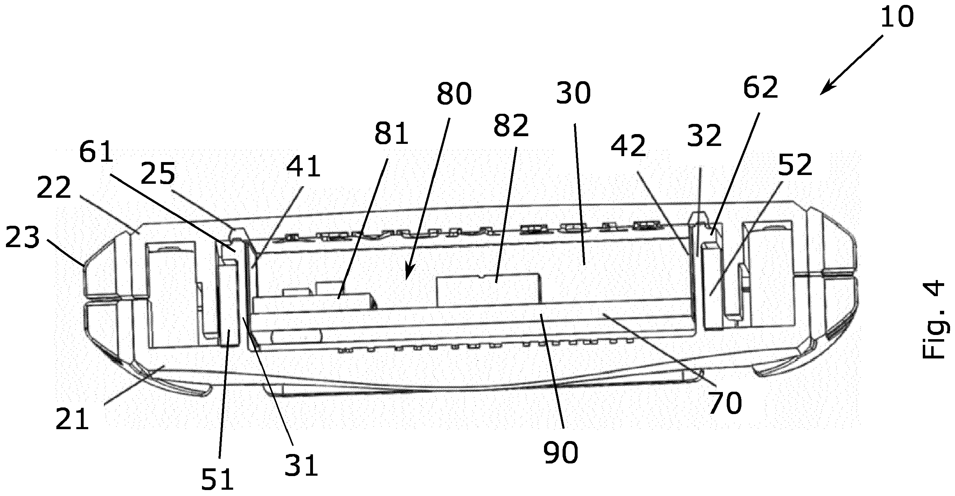

Fig. 1 to Fig. 4 show a first embodiment of an asset tracking device 10. Fig. 1 is thereby seen from cutting edge I of Fig. 3 and Fig. 4 is seen from cutting edge IV of Fig. 2. The asset tracking device 10 comprises a housing 20 of electrically isolating material. The housing 20 comprises a lower housing half 21 and an upper housing half 22, which are fixed together by several screws 24. On every edge of the housing 20, shock protecting rubber 23 is arranged, in order to protect the asset tracking device 10 from external shock. The housing 20 comprises an inner compartment 30, which is closed in a water- and dustproof. Therefore, between the first housing half 21 and the second housing half 22, a gasket 25 is provided.

The asset tracking device 10 further comprises a seal 50, including a first seal end portion 51, a second seal end portion 52 and a connecting portion 53.

The inner compartment 30 comprises a first wall 31 and a second wall 32, being arranged opposite to the first wall 31. On the inner surface of the first wall 31, a first electrode 41 is arranged. A second electrode 42 is arranged on the inner surface of the second wall 32. The inner compartment 30 furthermore comprises an evaluation device 70, a transmission device 80 and a localization device 90. The transmission device 80 comprises a radio unit 81 and an antenna 82.

On the outer surface of the first wall 31, a first seal receiving unit 61 for receiving the first seal end portion 51, is arranged. A second seal receiving unit 62 for receiving the second seal end portion 52 is arranged on the outer surface of the second wall 32.

The first seal receiving unit 61 and the second seal receiving unit 62 both comprise blade slots 63 for blades 64. The blades 64 provide a functionality for the first seal receiving unit 61 and the second seal receiving unit 62, such that a seal 50 to be received can only be moved in the inserting direction. Every movement in the opposite direction is blocked. If you try to move the seal 50 in the blocked direction by force, the blades 64 will cut the seal 50 and destroy the lead seal.

When a seal 50 is present, the seal 50 extends via the connecting portion 53 from the first seal receiving unit 61 to the second seal receiving unit 62. The connecting portion 53 has a length such that the connecting portion 53 and the asset tracking device 10 form a space, in which the asset or the access to an asset that should be lead sealed can be arranged.

For example, when forming a lead seal for a transport vehicle door, the seal 50 is guided though the handles (not shown) of the transport vehicle door and then, the first seal portion 51 is inserted into the first seal receiving unit 61 and the second seal portion 52 is inserted into the second seal receiving unit 62. Once inserted, the seal 50 cannot be removed from the asset tracking device 10 without destroying the seal 50. The handles of the transport vehicle door are then trapped between the seal 50 and the asset tracking device 10. Therefore, the transport vehicle door cannot be opened without destroying the lead seal. The seal 50 is either flexible or pre-bend in order to fit in the seal receiving unit 61, 62. Preferably, the seal 50 is pre-bend in a U-shape.

The evaluation unit 70 is electrically connected to the first electrode 41 and the second electrode 42. Therefore, the evaluation unit 70 can determine a charge transfer between the electrodes 41, 42 along the seal 50, in particular a voltage change of one electrode 42 induced by a voltage step applied to the other electrode 41.

When the seal 50 is inserted into the asset tracking device 10, the first seal end portion 51 is separated from the first electrode 41 by the first wall 31 and the second seal end portion 52 is separated from the second electrode 42 by the second wall 32. The first wall 31 and the second wall 32 are preferably formed especially thin. Since the first wall 31 and the second wall 32 are made from an electrically isolating material, the seal 50 is not electrically connected with the electrodes 41, 42. However, the seal 50 itself is a wire of electroconductive material, coated by plastic material. Since the first seal end portion 51 and the second end portion 52 are relatively close to the respective electrodes 41, 42, and the first seal end portion 51 and the second seal end portion 52 are connected by the connecting portion 53, the seal 50 is capacitvely coupled with the first electrode 41 and the second electrode 42. The presence of the undamaged seal 50 therefore has influence on the impedance of the first electrode 41 and the second electrode 42 and thus on the capability of transferring a charge along the seal 50. Furthermore, when the seal 50 is damaged, for example by cutting the seal 50, the influence of the seal 50 on the impedance of the first electrode 41 and the second electrode 42 is reduced. This change can be detected by the evaluation device 70. Based on the detected charge transfer between the electrodes 41, 42, the evaluation device 70 can make statements about the seal state, or in particular, if the seal 50 is undamaged or if the seal 50 is damaged. Therefore, the asset tracking device can automatically detect, if the lead seal is broken or not. Due to the simple implementation, the state of the seal 50 can be monitored with a relatively small power consumption. For example, if properties of the seal 50 are planned to be monitored directly, for example the impedance of the seal 50, a more complex implementation would be necessary consuming more power than using an induced voltage step.

When the seal 50 is cut, the remaining parts of the seal 50 can be removed from the asset tracking device 10 by guiding the parts of the seal 50 through the respective seal receiving unit 61, 62 in the insert direction.

Additionally, when a change of seal state is detected, the localization device 90 allows the localization of the device. Afterwards, the localization information and the change of seal state is transmitted to an external device by the transmission unit 80.

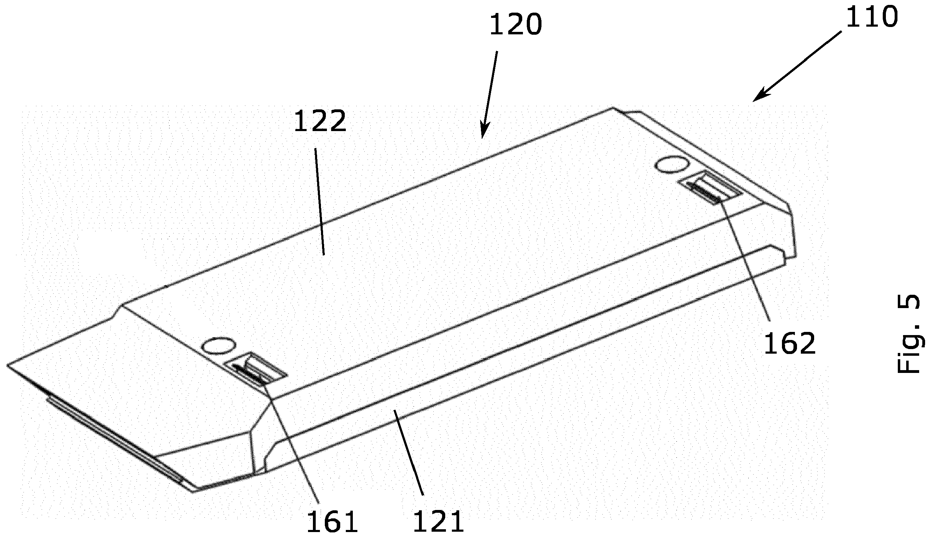

Fig. 5 describes an asset tracking device 110 of a second embodiment. In contrast to the first embodiment, the asset tracking device 110 comprises a housing 120 including a lower housing half 121 and an upper housing half 122. The first seal receiving unit 161 and the second seal receiving unit 162 are arranged on upper surface of the upper housing half 122. The seal 50 is therefore inserted into the first seal receiving unit 161 and the second seal receiving unit 162 perpendicular to the upper surface of the upper housing half 122.

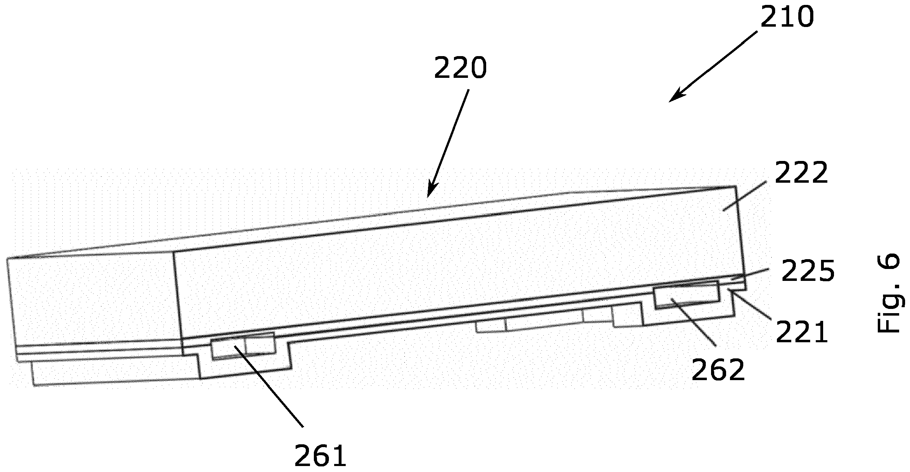

Fig. 6 shows an asset tracking device 210 of a second embodiment. The housing 220 is optimized for a flatter housing height, compared to the housing heights of the aforementioned embodiments, and injection moulding demands. The inner compartment (not shown) is formed water- and dustproof by a lower housing half 221 and an upper housing half 222, fixed together by a gasket 225. The first seal receiving unit 261 and the second seal receiving unit 262 are formed by the lower housing half 221, the upper housing half 222 and the gasket 225, in particular by melting those three parts together. This embodiment overall needs significantly less parts the first and second embodiment, but cannot be opened without destroying the housing 220. This embodiment is therefore especially suitable for one time-use. The electrode direction is at a 90° angle compared to the first embodiment.

### List of references

- 10: Asset tracking device
- 20: Housing
- 21: Lower housing half
- 22: Upper housing half
- 23: Shock protecting rubber
- 24: Screws
- 25: Gasket
- 30: Inner compartment
- 31: First wall
- 32: Second wall
- 41: First Electrode
- 42: Second electrode
- 50: Seal
- 51: First seal end portion
- 52: Second seal end portion
- 53: Connecting portion
- 61: First seal receiving unit
- 62: Second seal receiving unit
- 63: Blade slot
- 64: Blades
- 70: Evaluation device
- 80: Transmission device
- 81: Radio unit
- 82: Antenna
- 90: Localization device
- 110: Asset tracking device
- 120: Housing
- 121: Lower housing half
- 122: Upper housing half
- 161: First seal receiving unit
- 162: Second seal receiving unit
- 210: Asset tracking device
- 220: Housing
- 221: Lower housing half
- 222: Upper housing half
- 225: Gasket
- 261: First seal receiving unit
- 262: Second seal receiving unit

## Claims

1. Asset tracking device (10) comprising
an inner compartment (30);
at least two electrodes (41, 42), disposed spaced apart from each other in the inner compartment (30);
a seal (50), comprising electrically conductive material, being disposed outside of the inner compartment (30), such that the seal (50) capacitively couples the at least two electrodes (41, 42);
an evaluation device (70), which is electrically connected to the at least two electrodes (41, 42) and is configured to determine a charge transfer between the electrodes (41, 42) along the seal (50) induced by at least one voltage step applied to one of the electrodes (41, 42); wherein
the evaluation device (70) is configured to detect a change of seal (50) state based on the determined charge transfer.

2. Asset tracking device according to claim 1, comprising
a charge amplifier, which is configured to measure the charge transfer and to provide the charge transfer to the evaluation device (70).

3. Asset tracking device according to any of the preceding claims, wherein
the evaluation device (70) is configured to determine a charge transfer between the electrodes (41, 42) along the seal (50) induced by one single voltage step applied to the one of the electrodes.

4. Asset tracking device according to any of the preceding claims, **characterized by**
a localization device (90), configured to determine geographic data and information of the asset tracking device (10).

5. Asset tracking device according to any of the preceding claims, **characterized by**
a transmission device (80), which is configured to transmit the detected change of seal (50) state and/or the geographic data to an external device by radio frequency communication in a low-power wide-area network (LPWAN), in particular Sigfox.

6. Asset tracking device according to any of the preceding claims, **characterized in that**
the seal (50) comprises a first seal end portion (51), a second seal end portion (52) and a connecting portion (53), connecting the first seal end portion (51) and the second seal end portion (52), wherein the first seal end portion (51) and the second seal end portion (52) are at least partially received by the asset tracking device (10), wherein the connecting portion (53) and an outer wall of the asset tracking device form a space, in which parts of the asset and/or the access to the asset are disposed to form a lead seal.

7. Asset tracking device of any of the preceding claims, **characterized in that**
the inner compartment (30) comprises a first wall (31) and a second wall (32), the at least two electrodes (41, 42) comprise a first electrode and a second electrode, and the seal (50) comprises a first seal end portion (51), a second seal end portion (52) and a connecting portion (53), wherein the first electrode is disposed on an inner surface of the first wall (31) and the first seal end portion (51) is disposed on an outer surface of the first wall (31), wherein the second electrode is disposed on an inner surface of the second wall (32) and the second seal end portion (52) is disposed on an outer surface of the second wall (32).

8. Asset tracking device according to any of the claims 6 or 7, **characterized in that**
the seal (50) is configured to be flexible and/or pre-bend, wherein the seal (50) in particular is configured to have a U-shape, wherein preferably the first seal end portion (51) and the second seal end portion (52) form the legs and the connecting portion (53) forms the connecting part of the U-shape.

9. Asset tracking device according to any of the preceding claims, **characterized by**
a seal receiving unit (61, 62), which is disposed outside of the inner compartment (30) and is configured to at least partially receive the seal (50), wherein preferably the seal receiving unit (61, 62) comprises a mechanical self-locking mechanism, which is configured to lock the seal (50) in only one direction.

10. Asset tracking device according to any of the preceding claims, **characterized in that**
the evaluation device (70) is configured to determine the charge transfer between the electrodes (41, 42) in predetermined intervals, in particular once per minute.

11. Asset tracking device according to any of the preceding claims, **characterized in that**
the inner compartment (30) is made of an electrically isolating material.

12. Method for sealing an asset with an asset tracking device according to any of claims 1 to 11.

13. Method according to claim 12, **characterized in that**
the asset is a transport container, in particular a transport vehicle.

14. Method of any according to any of the claims 12 or 13, comprising the steps capacitive coupling of the at least two electrodes (41, 42) by a seal (50);
determining the charge transfer between the electrodes (41, 42) along the seal (50) and detecting a change of seal state by an evaluation device (70) based on the determined charge transfer;
preferably transmitting the change of seal state and/or further preferably geodata to an external device, preferably by radio frequency communication, by the transmission device (80).

15. Vehicle with an asset tracking device according to any of claims 1 to 11.
